# EUROPEAN PATENT SPECIFICATION

(11) **EP 4 351 294 B1**
(45) Date of publication and mention of the grant of the patent: **09.12.2026**
(21) Application number: 23769091.2
(22) Date of filing: 01.08.2023
(51) Int. Cl.: H05K 9/00, H04M 1/23, H04M 1/02, H05K 5/06, H05K 1/02

(54) **ELECTRONIC DEVICE INCLUDING ELECTROSTATIC DISCHARGE PATH**
ELEKTRONISCHE VORRICHTUNG MIT ELEKTROSTATISCHEM ENTLADUNGSPFAD
DISPOSITIF ÉLECTRONIQUE COMPRENANT UN TRAJET DE DÉCHARGE ÉLECTROSTATIQUE

(30) Priority: 17.08.2022 KR 20220102554; 07.09.2022 KR 20220113750
(43) Date of publication of application: 10.04.2024
(73) Proprietor: Samsung Electronics Co., Ltd., Suwon-si, Gyeonggi-do 16677 (KR)
(72) Inventor: KIM, Minhak, Suwon-si, Gyeonggi-do 16677 (KR); LEE, Seunghwan, Suwon-si, Gyeonggi-do 16677 (KR); AHN, Kyooil, Suwon-si, Gyeonggi-do 16677 (KR); LEE, Hanyeop, Suwon-si, Gyeonggi-do 16677 (KR); LEE, Hongkyu, Suwon-si, Gyeonggi-do 16677 (KR)
(74) Representative: Gulde & Partner
(86) International application number: PCT/KR2023/011235
(87) International publication number: WO 2024/039109

(56) References cited:
- WO-A1-2020/189883
- JP-A- 2010 072 096
- KR-A- 20220 050 454
- KR-B1- 101 285 273
- US-A1- 2004 047 107
- US-A1- 2015 216 024
- US-A1- 2015 216 024
- US-A1- 2017 077 696

## Description

### [Technical Field]

Embodiments of the disclosure relate to an electronic device including an electrostatic discharge path.

### [Background Art]

An electronic device may include one or more keys and sensors. For example, one or more keys (e.g., a volume control key and/or a power key) and sensors (e.g., a fingerprint sensor) may be disposed on a side surface of a housing of an electronic device. Gaps may be formed between the side surface of the housing of the electronic device and the one or more keys and sensors disposed on the side surface. An electrostatic discharge (ESD) phenomenon in which charges accumulated on a surface of the electronic device instantaneously move to electronic components disposed inside the electronic device may occur through the gaps.

The following prior art publications are related to electronic devices including an electrostatic discharge path:
US 2015/216024 Al entitled "Electronic devices having electrostatic discharge paths";
US 2004/047107 Al entitled "ESD protection circuit for touch button";
WO 2020/189883 Al entitled "Electronic device comprising electrostatic induction structure".

### [Disclosure of Invention]

### [Technical Problem]

When the ESD phenomenon occurs, the electronic components disposed inside the electronic device may be damaged, and accordingly, the electronic device may not operate properly or may be deteriorated in performance.

An electronic device according to an embodiment of the disclosure may be provided with an ESD path configured to allow charges accumulated on a surface of the electronic device to move to a ground via a connection between at least one conductive member disposed inside the electronic device and the ground.

### [Solution to Problem]

An object of the present invention is an electronic device comprising: a housing comprising a first opening; a key button disposed to be at least partially exposed outside through the first opening; the electronic device being characterized in that it further comprises: a flexible circuit board, FPCB, comprising one end attached to the key button and another end electrically connected to a printed circuit board disposed in an inner space of the housing; a key structure, in the inner space of the housing, configured to support at least a portion of a key button assembly comprising the key button and the flexible circuit board in the inner space of the housing, the key structure comprising a second opening; a conductive plate disposed on the key structure to close the second opening; and a support member in which the key structure is accommodated, wherein the FPCB extends between the key structure and the conductive plate from the first opening through the second opening, and wherein at least a portion of the conductive plate is electrically connected, via at least a partial area of the FPCB, to a ground inside the electronic device, the ground being connected to the support member.

Preferably, a tension rib is provided in at least a portion of the conductive plate.

Preferably, the tension rib is provided in a slit shape in at least a portion of the conductive plate.

Preferably, a lower surface of the tension rib in the conductive plate has a step lower than an upper surface of the conductive plate on which the tension rib is not provided.

Preferably, the FPCB comprises alternately stacked insulating layers and conductive layers, wherein an external surface of the FPCB is the insulating layer, wherein at least a partial area of the external insulating layer is removed so that at least the partial area of the conductive layer provided under the external insulating layer is not covered by the external insulating layer to elastically contact the tension rib.

Preferably, an electrostatic discharge, ESD, path is provided such that charges introduced from outside the key button are transferred to the ground of the printed circuit board via the FPCB and the at least the partial area of the FPCB with which one surface of the tension rib of the conductive plate is in contact, and/or wherein the ESD path is provided such that charges introduced from outside of the key button are transferred to the ground inside the electronic device via the FPCB, at least the partial area of the FPCB with which the one surface of the tension rib of the conductive plate is in contact, and the support member.

Preferably, the area of the conductive plate, which is in electrical contact with at least the partial area of the FPCB, has an inverted triangular shape, a shape rounded at corners, or an inverted trapezoidal shape.

Preferably, the electronic device further comprises a first waterproof tape and a second waterproof tape disposed between the key structure and the conductive plate, and wherein the first waterproof tape and the second waterproof tape are disposed under the conductive plate, and wherein the conductive plate is configured to press the first waterproof tape and the second waterproof tape to prevent the first waterproof tape and the second waterproof tape from lifting, wherein the conductive plate is fastened to one surface of the support member disposed in the inner space of the electronic device via a locking device.

Preferably, the key button assembly further comprises a sensor circuit.

Preferably, the electronic device further comprises: a sensor circuit disposed to be at least partially exposed to outside through the first opening and comprising a first conductive pattern; wherein the FPCB comprises a second conductive pattern electrically connected to the first conductive pattern and a ground of the printed circuit board.

Preferably, the first conductive pattern is provided inside the sensor circuit in a form of surrounding a plurality of terminals included in the sensor circuit, wherein the second conductive pattern is provided inside the FPCB in a form of surrounding a plurality of terminals included in the FPCB, and wherein the first conductive pattern and the second conductive pattern are electrically connected to each other via a conductive adhesive.

Preferably, the conductive adhesive contains silver epoxy, and wherein the conductive adhesive is cured by a heat curing method or an ultraviolet curing method.

Preferably, an electrostatic discharge, ESD, path is provided such that charges introduced from outside the key button are transferred to the first conductive pattern, the second conductive pattern, and the ground of the printed circuit board.

### [Advantageous Effects of Invention]

An electronic device according to an embodiment of the disclosure is provided with an ESD configured to allow charges accumulated on a surface of the electronic device to be transferred to a ground via a connection between at least one conductive member disposed inside the electronic device and the ground. As a result, it is possible to prevent electronic components disposed in the inner space of the electronic device from being damaged. Accordingly, the performance of the electronic device can also be improved.

### [Brief Description of Drawings]

FIG. 1 is a block diagram of an electronic device according to an embodiment of the disclosure in a network environment.
FIG. 2A is a front perspective view of an electronic device according to an embodiment of the disclosure.
FIG. 2B is a rear perspective view of the electronic device of FIG. 2A according to an embodiment of the disclosure.
FIG. 3 is an exploded perspective view of the electronic device according to an embodiment of the disclosure.
FIG. 4 is a cross-sectional view taken along line A-A' in FIG. 2A according to an embodiment of the disclosure.
FIG. 5A is a view illustrating a state in which a conductive plate is disposed inside an electronic device according to an embodiment of the disclosure.
FIG. 5B illustrates a view of the conductive plate and an enlarged view of at least a portion of the conductive plate, according to an embodiment of the disclosure.
FIG. 6A is a cross-sectional view taken along line B-B' in FIG. 5B according to an embodiment of the disclosure.
FIG. 6B is a view illustrating examples of shapes of a portion indicated by reference number 630 in FIG. 6A according to an embodiment of the disclosure.
FIG. 7A is a view illustrating a conductive pattern provided in a sensor circuit according to an embodiment of the disclosure.
FIG. 7B is a view illustrating a conductive pattern provided in a flexible circuit board according to an embodiment of the disclosure.
FIG. 7C is a view illustrating a state in which the sensor circuit and the flexible circuit board according to an embodiment of the disclosure overlap each other.
FIG. 8A is a view illustrating a key button assembly according to an embodiment of the disclosure.
FIG. 8B is a cross-sectional view taken along line C-C' of FIG. 8A according to an embodiment of the disclosure.

### [Mode for the Invention]

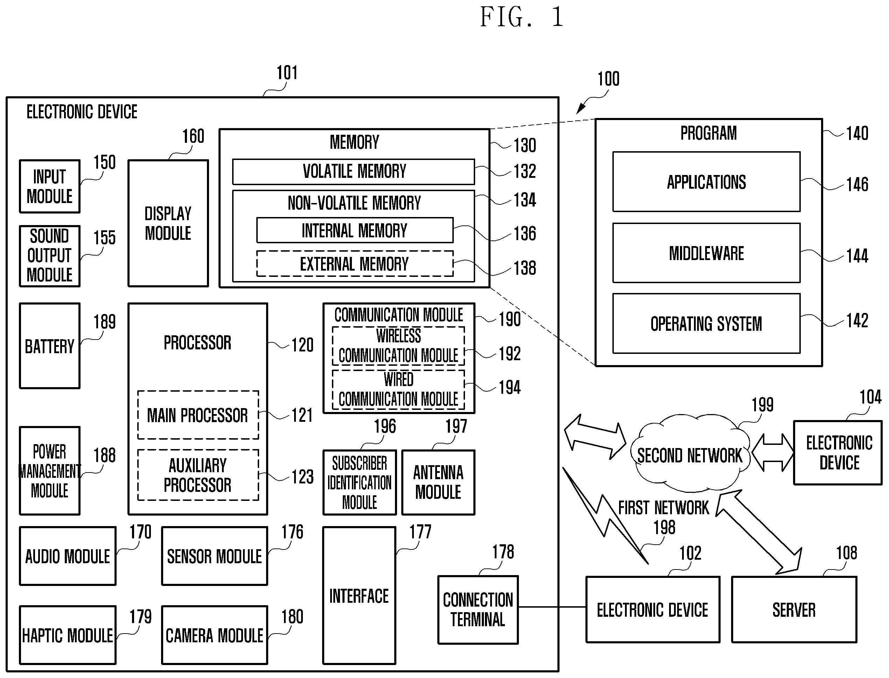

FIG. 1 is a block diagram illustrating an electronic device in a network environment according to various embodiments.

Referring to FIG. 1, an electronic device 101 in a network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connection terminal 178, a haptic module 179, a camera module 180, a power management module 188, a battery 189, a communication module 190, a subscriber identification module (SIM) 196, or an antenna module 197. In some embodiments, at least one of the components (e.g., the connection terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134. The non-volatile memory 134 may include an internal memory 136 and/or an external memory 138.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) (e.g., speaker or headphone) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., through wires) or wirelessly. According to an embodiment, the interface 177 may include, for example, a high-definition multimedia interface (HDMI), a universal serial bus (USB) interface, a secure digital (SD) card interface, or an audio interface.

The connection terminal 178 may include a connector via which the electronic device 101 may be physically connected with the external electronic device (e.g., the electronic device 102). According to an embodiment, the connection terminal 178 may include, for example, an HDMI connector, a USB connector, an SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., an application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, Wi-Fi direct, or infrared data association (IrDA)) or the second network 199 (e.g., a long-range communication network, such as a legacy cellular network, a fifth generation (5G) network, a next-generation communication network, the Internet, or a computer network (e.g., LAN or wide area network (WAN))). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large-scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., an mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra-low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively," as "coupled with," "coupled to," "connected with," or "connected to" another element (e.g., a second element), it means that the element may be coupled with the other element directly (e.g., through wires), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry." A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

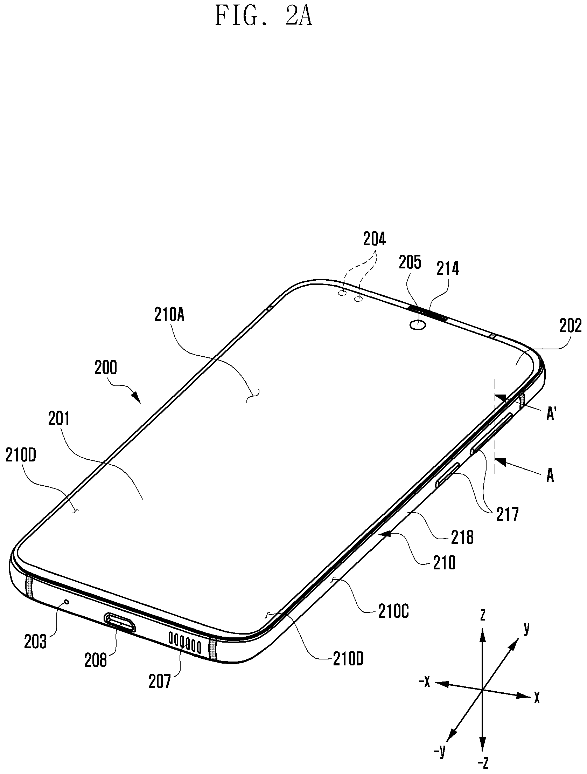

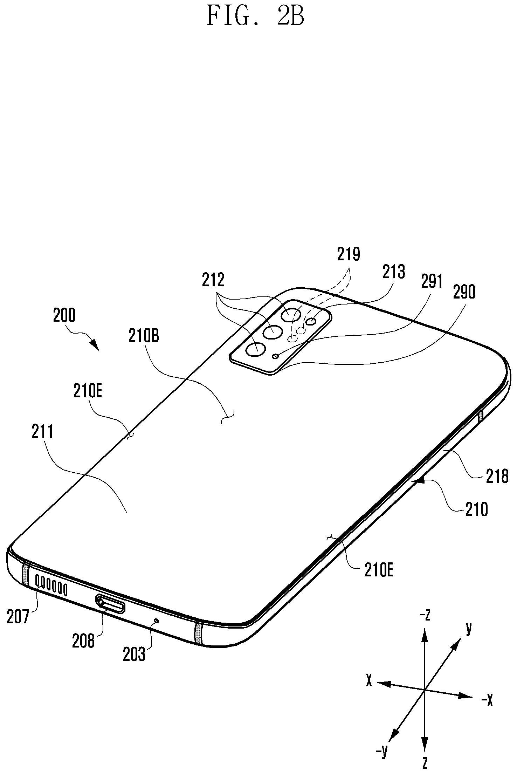

FIG. 2A is a perspective view showing a front surface of an electronic device according to an embodiment of the disclosure. FIG. 2B is a perspective view showing a rear surface of the electronic device shown in FIG. 2A according to an embodiment of the disclosure.

The electronic device 200 of FIG. 2A and FIG. 2B may be at least partially similar to the electronic device 101 of FIG. 1 or may further include other embodiments of an electronic device.

Referring to FIGS. 2A and 2B, an electronic device 200 may include a housing 210 that includes a first surface (or front surface) 210A, a second surface (or rear surface) 210B, and a lateral surface 210C that surrounds a space between the first surface 210A and the second surface 210B. The housing 210 may refer to a structure that forms a part of the first surface 210A, the second surface 210B, and the lateral surface 210C. The first surface 210A may be formed of a front plate 202 (e.g., a glass plate or polymer plate coated with a variety of coating layers) at least a part of which is substantially transparent. The second surface 210B may be formed of a rear plate 211 which is substantially opaque. The rear plate 211 may be formed of, for example, coated or colored glass, ceramic, polymer, metal (e.g., aluminum, stainless steel (STS), or magnesium), or any combination thereof. The lateral surface 210C may be formed of a lateral bezel structure (or "lateral member") 218 which is combined with the front plate 202 and the rear plate 211 and includes a metal and/or polymer. The rear plate 211 and the lateral bezel structure 218 may be integrally formed and may be of the same material (e.g., a metallic material such as aluminum).

The front plate 202 may include two first regions 210D disposed at long edges thereof, respectively, and bent and extended seamlessly from the first surface 210A toward the rear plate 211. Similarly, the rear plate 211 may include two second regions 210E disposed at long edges thereof, respectively, and bent and extended seamlessly from the second surface 210B toward the front plate 202. The front plate 202 (or the rear plate 211) may include only one of the first regions 210D (or of the second regions 210E). The first regions 210D or the second regions 210E may be omitted in part. When viewed from a lateral side of the electronic device 200, the lateral bezel structure 218 may have a first thickness (or width) on a lateral side where the first region 210D or the second region 210E is not included, and may have a second thickness, being less than the first thickness, on another lateral side where the first region 210D or the second region 210E is included.

The electronic device 200 may include at least one of the following: a display 201 (e.g., a display module 160 of FIG. 1), an input device 203 (e.g., an input module 150 of FIG. 1), one or more sound output devices 207, 214 (e.g., a sound output module 155 of FIG. 1), one or more sensor modules 204, 219 (e.g., a sensor module 176 of FIG. 1), one or more camera modules 205, 212, 213 (e.g., a camera module 180 of FIG. 1), a key input device 217, an indicator, a connector hole 208 (e.g., a connection terminal 178 of FIG. 1). The electronic device 200 may omit at least one (e.g., the key input device 217 or the indicator) of the above components, or may further include other components.

The display 201 may be exposed through a substantial portion of the front plate 202, for example. At least a part of the display 201 may be exposed through the front plate 202 that forms the first surface 210A and the first region 210D of the lateral surface 210C. The display 201 may be combined with, or adjacent to, a touch sensing circuit, a pressure sensor capable of measuring the touch strength (pressure), and/or a digitizer for detecting a stylus pen. At least a part of the sensor modules 204 and 219 and/or at least a part of the key input device 217 may be disposed in the first region 210D and/or the second region 210E.

The input device 203 may include a microphone. In some embodiments, the input device 203 may include a plurality of microphones arranged to sense the direction of the sound. The sound output devices 207 and 214 may include speakers. The speakers may include an external speaker 207 and a receiver 24 for a call. In some embodiments, the microphone, the speakers, and the connector hole 208 are disposed in the space of the electronic device 200 and may be exposed to the external environment through at least one hole formed in the housing 210. A hole formed in the housing 210 may be used in common for the microphone and speakers. The sound output devices 207 and 214 may include a speaker (e.g., a piezo speaker) that operates while excluding a hole formed in the housing 210.

The sensor modules 204 and 219 may generate electrical signals or data corresponding to an internal operating state of the electronic device 200 or to an external environmental condition. The sensor modules 204 and 219 may include a first sensor module 204 (e.g., a proximity sensor) and/or a second sensor module (e.g., a fingerprint sensor) disposed on the first surface 210A of the housing 210, and/or a third sensor module 219 (e.g., a heart rate monitor (HRM) sensor) disposed on the second surface 210B of the housing 210. The fingerprint sensor may be disposed on the first surface 210A of the housing 210. A fingerprint sensor (e.g., an ultrasonic method or an optical fingerprint sensor) may be disposed under the display 201 of the first surface 210A. The fingerprint sensor may be disposed on the second surface 210B as well as the first surface 210A (e.g., the display 201) of the housing 210. The electronic device 200 may further include at least one of the following: a gesture sensor, a gyro sensor, an air pressure sensor, a magnetic sensor, an acceleration sensor, a grip sensor, a color sensor, an infrared (IR) sensor, a biometric sensor, a temperature sensor, a humidity sensor, an illuminance sensor.

The camera modules 205, 212 and 213 may include a first camera device (e.g., camera module 205) disposed on the first surface 210A of the electronic device 100, and a second camera device (e.g., camera module 212) and/or a flash (e.g., camera module 213) disposed on the second surface 210B. The camera module 205 or the camera module 212 may include one or more lenses, an image sensor, and/or an image signal processor. The flash (e.g., camera module 213) may include, for example, a light emitting diode or a xenon lamp. Two or more lenses (infrared cameras, wide angle and telephoto lenses) and image sensors may be disposed on one side of the electronic device 200.

The key input device 217 may be disposed on the lateral surface 210C of the housing 210. The electronic device 200 may not include some or all of the key input device 217 described above, and the key input device 217 which is not included may be implemented in another form such as a soft key on the display 201. The key input device 217 may include the sensor module disposed on the second surface 210B of the housing 210. **In** another embodiment, the key input device 217 may be implemented using a pressure sensor included in the display 201.

The indicator may be disposed on the first surface 210A of the housing 210. For example, the indicator may provide status information of the electronic device 200 in an optical form. The indicator may provide a light source associated with the operation of the camera module 205. The indicator may include, for example, a light emitting diode (LED), an infrared (IR) LED, or a xenon lamp.

The connector hole 208 may include a first connector hole adapted for a connector (e.g., a universal serial bus (USB) connector or an interface connector port module) for transmitting and receiving power and/or data to and from an external electronic device. The connector hole 208 may include a second connector hole adapted for a connector (e.g., an earphone jack) for transmitting and receiving an audio signal to and from an external electronic device.

Some camera module 205 of camera modules 205 and 212, some sensor module 204 of sensor modules 204 and 219, or an indicator may be arranged to be exposed through a display 201. For example, the camera module 205, the sensor module 204, or the indicator may be arranged in the internal space of an electronic device 200 so as to be brought into contact with an external environment through an opening of the display 201, which is perforated up to a front plate 202. The area facing the camera module 205 of the display 201 may be formed as a transparent area having a designated transmittance as a part of an area displaying content. The transmissive region may have a transmittance ranging from about 5% to about 20%. Such a transmissive region may include a region overlapping an effective region (e.g., an angle of view region) of the camera module 205 through which light for generating an image by an image sensor passes. The transparent area of the display 201 may include an area having a lower pixel density or wiring density or both than the surrounding area. The transmissive area may replace the aforementioned opening. The camera module 205 may include an under-display camera (UDC). The sensor module 204 may be arranged to perform functions without being visually exposed through the display 201 in the internal space of the electronic device 200. For example, in this case, an area of the display 201 facing the sensor module may not require a perforated opening.

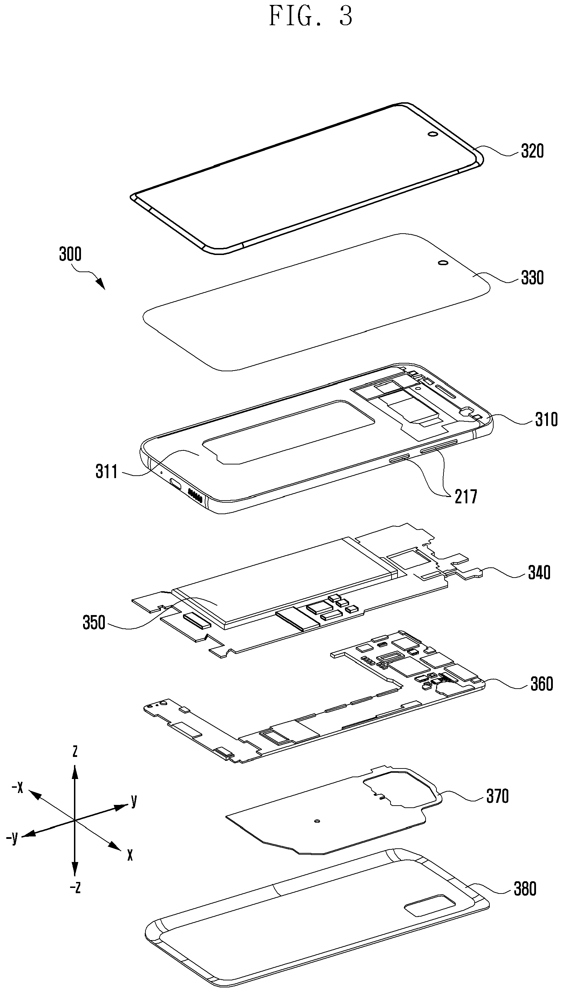

FIG. 3 is an exploded perspective view of the electronic device according to an embodiment of the disclosure.

The electronic device 300 shown in FIG. 3 may be similar, at least in part, to the electronic device 100 in FIG 1 or the electronic device 200 in FIGS. 2A and 2B, or may further include another embodiment of the electronic device.

Referring to FIG. 3, an electronic device 300 may include a lateral member 310 (e.g., lateral bezel structure), a first support member 311 (e.g., a bracket), a front plate 320 (e.g., a front cover), a display 330, a printed circuit board (PCB) 340, a battery 350, a second support member 360 (e.g., a rear case), an antenna 370, and a rear plate 380 (e.g., a rear cover). The electronic device 300 may omit at least one (e.g., the first support member 311 or the second support member 360) of the above components or may further include another component. Some components of the electronic device 300 may be the same as or similar to those of the electronic device 200 shown in FIG. 2A or FIG. 2B, thus, descriptions thereof are omitted below.

The first support member 311 is disposed inside the electronic device 300 and may be connected to, or integrated with, the lateral member 310. The first support member 311 may be formed of, for example, a metallic material and/or a non-metal (e.g., polymer) material. The first support member 311 may be combined with the display 330 at one side thereof and also combined with a PCB 340 at the other side thereof. On a PCB 340, a processor (e.g., a processor 120 of FIG. 1), a memory (e.g., a memory 130 of FIG. 1), and/or an interface (e.g., an interface 177 of FIG. 1) may be mounted.

The processor may include, for example, one or more of a central processing unit (CPU), an application processor (AP), a graphics processing unit (GPU), an image signal processor (ISP), a sensor hub processor, or a communications processor (CP).

The memory may include, for example, one or more of a volatile memory (e.g., a volatile memory 132 of FIG. 1) and a non-volatile memory (e.g., a non-volatile memory 134 of FIG. 1).

The interface may include, for example, a high definition multimedia interface (HDMI), a USB interface, a secure digital (SD) card interface, and/or an audio interface. The interface may electrically or physically connect the electronic device 300 with an external electronic device and may include a USB connector, an SD card/multimedia card (MMC) connector, or an audio connector.

The battery 350 is a device for supplying power to at least one component of the electronic device 300, and may include, for example, a non-rechargeable primary battery, a rechargeable secondary battery, or a fuel cell. At least a part of the battery 350 may be disposed on substantially the same plane as a PCB 340. The battery 350 may be integrally disposed within the electronic device 300, and may be detachably disposed from the electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may perform short-range communication with an external device, or transmit and receive power required for charging wirelessly. An antenna structure may be formed by a part or combination of the lateral member 310 and/or the first support member 311.

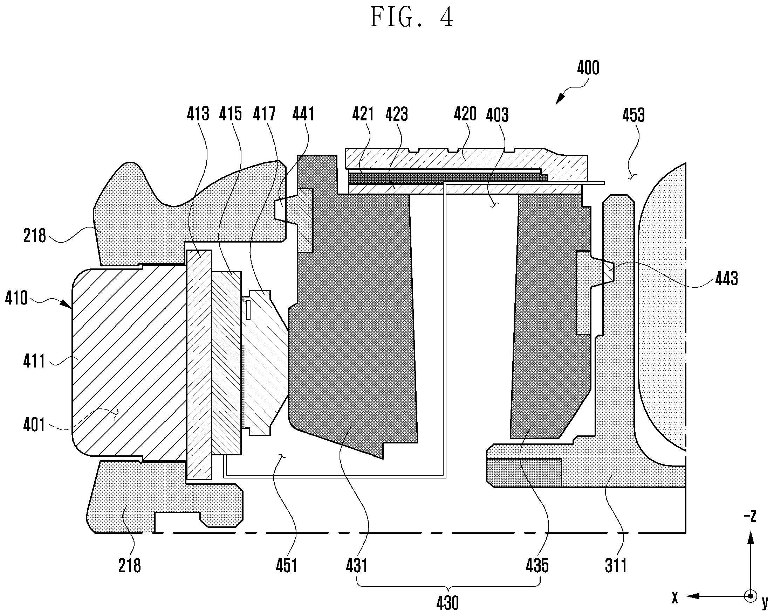

FIG. 4 is a cross-sectional view taken along line A-A' in FIG. 2A according to an embodiment of the disclosure.

Referring to FIG. 4, an electronic device 400 (e.g., the electronic device 101 of FIG. 1, the electronic device 200 of FIGS. 2A and 2B, or the electronic device 300 of FIG. 3) may include a housing (e.g., the housing 210 of FIGS. 2A and 2B). In an embodiment, the housing 210 may include a front surface plate (e.g., the front surface plate 202 of FIG. 2A) facing a first direction (e.g., the z-axis direction), a rear surface plate (e.g., the rear surface plate 211 of FIG. 2B) facing a second direction (e.g., the -z-axis direction) opposite to the first direction, and a side surface member (e.g., the side surface member 218 in FIGS. 2A and 2B) facing a third direction (e.g., the ±x axis-direction) perpendicular to each of the first and second directions and surrounding at least a portion of the space between the front surface plate 202 and the rear surface plate 211.

In an embodiment, a key button assembly 410 may include at least one of the following elements: a key button 411, solder 413, a flexible printed circuit board (FPCB) 415, a dome switch 417.

In an embodiment, the key button assembly 410 may be disposed on at least a partial of the side surface member 218. In an embodiment, a first opening 401 may be provided (e.g., formed) in a partial area of the side member 218 to expose a partial surface of the key button assembly 410 (e.g., the key button 411) to outside.

In an embodiment, the solder 413 may electrically connect the key button 411 and the flexible circuit board 415 to each other.

In an embodiment, the flexible circuit board 415 may be an electrical connection member configured to connect the key button assembly 410 to a printed circuit board (e.g., the printed circuit board 340 of FIG. 3). For example, one end of the flexible circuit board 415 may be electrically connected to the solder 413 (or the key button 411), and the other end may be electrically connected to the printed circuit board 340.

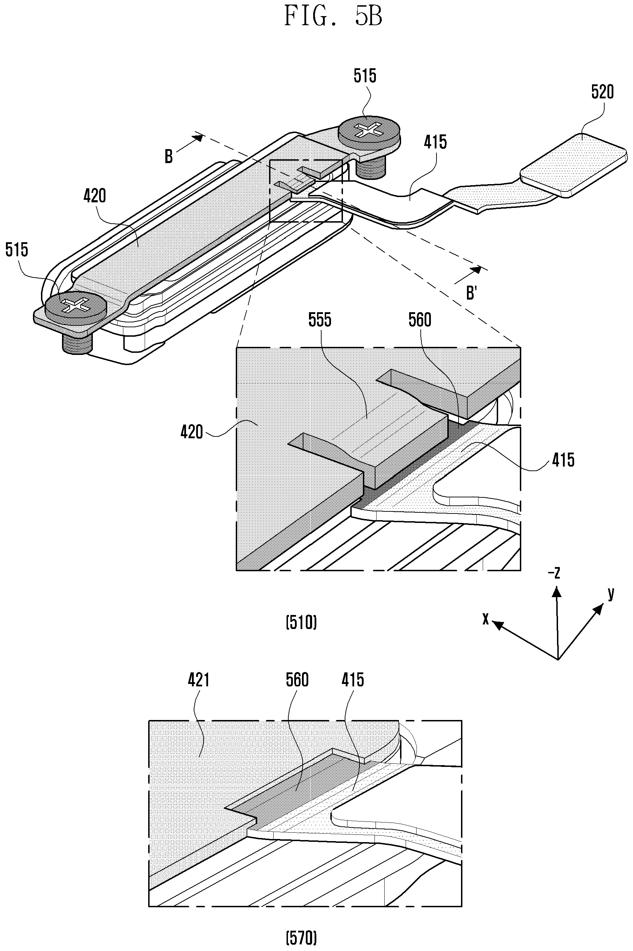

In an embodiment, the other end of the flexible circuit board 415 may be provided with a connector (e.g., connector 520 of FIG. 5B) and may be connected to the printed circuit board (PCB) 340 via the connector 520. However, the disclosure is not limited thereto.

Consequently, the electronic device is provided with an ESD configured to allow charges accumulated on a surface of the electronic device (i.e the key button 411) to be transferred to a drain via the flexible circuit board 415.

In an embodiment, the housing 210 may include a key structure 430 configured to allow the key button assembly 410 to be placed between the side surface member 218 and a support member (e.g., the first support member 311 of FIG. 3). For example, the key structure 430 may include a key bracket 431 and/or a front dummy 435 configured to be capable of supporting the key button assembly 410 to be operable. The key bracket 431 may be accommodated in a portion of the support member 311 to support the movement of the key button 411 to a specific direction (e.g., the ±x-axis direction). The front dummy 435 may be a protective member configured to protect the key button assembly 410 accommodated in a portion of the housing 210 (e.g., the first opening 401). In an embodiment, the key bracket 431 may be made of a polycarbonate (PC) material.

In an embodiment, the key bracket 431 may be fixed to the side surface member 218 via a first coupling member 441. The front dummy 435 may be fixed to the first support member 311 via a second coupling member 443. For example, the first coupling member 441 and the second coupling member 443 may be made of liquid silicone rubber (LSR) that serves to provide shockproof and waterproof protection.

In an embodiment, the electronic device 400 may include at least one waterproof structure. The waterproof structure may be mounted between the support member 311 and the key button assembly 410 to seal the space between a first space 451 in which the key button assembly 410 is located and a second space 453 in which the printed circuit board 340 is located. In an embodiment, the waterproof structure may include a conductive plate 420 and one or more waterproof tapes that spatially isolate the first space 451 and the second space 453 from each other (or closes the second opening 403). For example, the one or more waterproof tapes may include a first waterproof tape 421 and a second waterproof tape 423. However, the disclosure is not limited thereto.

In an embodiment, the first waterproof tape 421 and the second waterproof tape 423 may be double-sided tapes. In an embodiment, the second waterproof tape 423 may be attached to one surface of the first waterproof tape 421 and the conductive plate 420 may be attached to the other surface of the first waterproof tape 421. The first waterproof tape 421 may be attached to one surface of the second waterproof tape 423, and the key structure 430 (e.g., the key bracket 431 and/or the front dummy 435) may be attached to the other surface of the second waterproof tape 423.

In an embodiment, the conductive plate 420 may be disposed above the first waterproof tape 421 (e.g., in the z-axis direction) to press the first waterproof tape 421 and the second waterproof tape 423 disposed below the conductive plate 420 (e.g., in the -z-axis direction) so that the first waterproof tape 421 and the second waterproof tape 423 can be prevented from lifting. In an embodiment, the conductive plate 420 may include steel use stainless (SUS) (e.g., stainless steel (STS)).

In an embodiment, at least a portion of the flexible circuit board 415 may pass through the space between the first waterproof tape 421 and the second waterproof tape 423 and through the space between at least a portion of the conductive plate 420 and the second waterproof tape 423. At least a portion of the flexible circuit board 415 may pass through the space between the first waterproof tape 421 and the second waterproof tape 423 and through the space between at least a portion of the conductive plate 420 and the second waterproof tape 423, and may then be electrically connected to the printed circuit board 340.

In an embodiment, the flexible circuit board 415 may include insulating layers and conductive layers (e.g., copper foils), which are alternately stacked, and an external surface of the flexible circuit board 415 may be made of an insulating layer. In an embodiment, at least a portion of the insulating layer on the external surface of the flexible circuit board 415 may be removed. As at least a portion of the insulating layer on the external surface of the flexible circuit board 415 is removed, at least a portion of the conductive layer disposed under the insulating layer may be exposed to outside.

In an embodiment, a tension rib (e.g., the tension rib 555 of FIG. 5B) may be provided (e.g., formed) on at least a portion of the conductive plate 420. For example, the tension rib 555 may be provided in a slit shape in at least a portion of the conductive plate 420.

In an embodiment, as at least a portion of the insulating layer on the external surface of the flexible circuit board 415 is removed, at least a partial area of the conductive plate 420 may be in contact with at least a portion of the conductive layer exposed to outside.

In various embodiments, as at least a portion of the conductive plate 420 is in contact with at least a portion of the conductive layer exposed to outside due to the removal of the insulating layer on the external surface of the flexible circuit board 415, the electronic device 400 may be provided (e.g., formed) with an ESD path such that the charges accumulated (or generated) outside the electronic device 400 (e.g., the charges generated and accumulated on the key button 411) are transferred to the flexible circuit board 415, the area of the flexible circuit board 415 with which at least a portion of the conductive plate 420 is in contact (e.g., at least a partial area of the conductive layer of the flexible circuit board 415 exposed to outside), and a ground inside the electronic device 400, the ground being connected to the support member 311. However, the disclosure is not limited thereto, and the electronic device 400 may be configured such that the charges accumulated (or generated) outside the electronic device 400 (e.g., the charges generated and accumulated on the key button 411) are transferred to the flexible circuit board 415, the area of the flexible circuit board 415 with which at least a portion of the conductive plate 420 is in contact (e.g., at least a partial area of the conductive layer of the flexible circuit board 415 exposed to outside), and a ground of the printed circuit board 340.

In various embodiments of the disclosure, by providing a transfer path of charges accumulated (or generated) outside the electronic device 400 (e.g., an ESD path), it is possible to prevent electronic components disposed in an inner space of the electronic device 400 from being damaged.

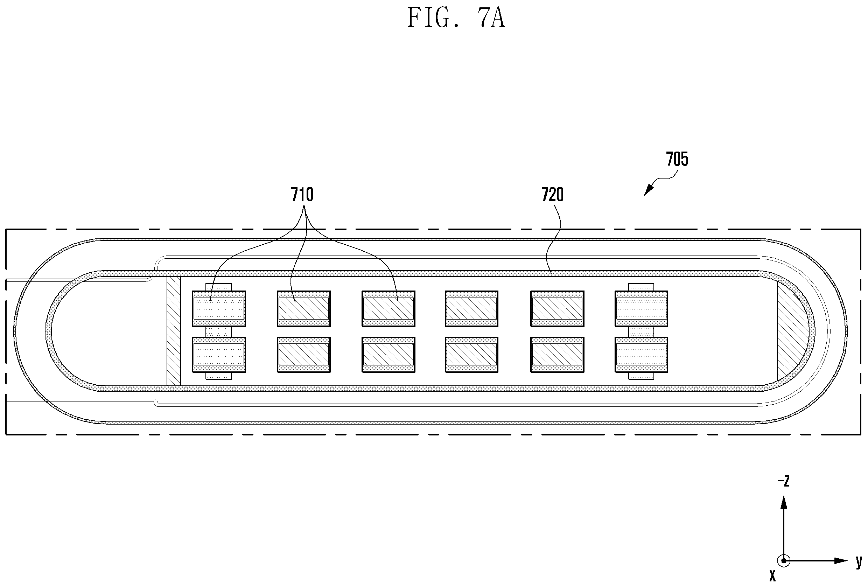

Although not illustrated in FIG. 4, according to various embodiments, the key button assembly 410 may further include a sensor circuit (e.g., the sensor circuit 705 of FIG. 7A).

In an embodiment, the sensor circuit 705 may include a biometric sensor, which may include, for example, a fingerprint sensor. The first opening 401 provided (e.g., formed) in at least a partial area of the side surface member 218 may expose a sensing surface (e.g., an area configured to sense a user's biometric information (e.g., a fingerprint)) of the sensor circuit 705 (e.g., a biometric sensor) of the key button assembly 410.

In various embodiments, when the key button assembly 410 further includes the sensor circuit 705, the solder 413 may be a sensor solder. The sensor circuit 705 and the flexible circuit board 415 may be electrically connected to each other via the sensor solder.

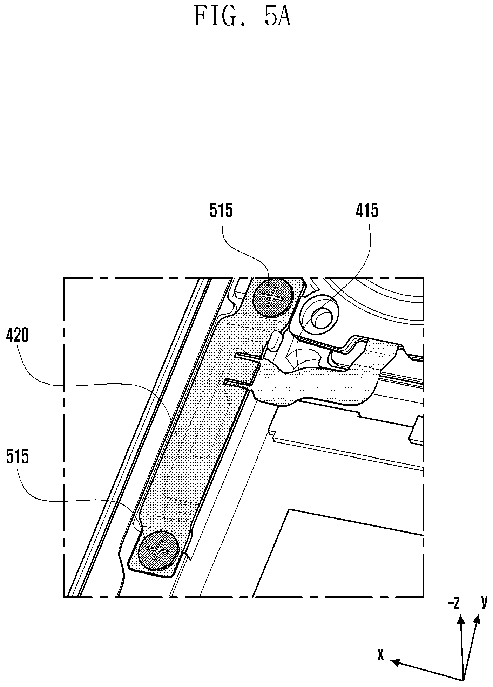

FIG. 5A is a view illustrating a state in which the conductive plate 420 is disposed inside the electronic device 400 according to an embodiment of the disclosure. FIG. 5B illustrates a view of the conductive plate 420 and an enlarged view of at least a portion of the conductive plate 420, according to an embodiment of the disclosure.

Referring to FIG. 5A, the conductive plate 420 may be fastened to a surface (e.g., the surface facing the -z-axis direction) of a support member (e.g., the first support member 311 in FIG. 3) disposed in the inner space of an electronic device (e.g., the electronic device 400 of FIG. 4) via a locking device 515 (e.g., a screw or a fastening element). Although two locking devices 515 are illustrated, the disclosure is not limited thereto.

As illustrated in FIG. 4, the conductive plate 420 may be in the fixed state by being disposed above the first waterproof tape (e.g., the first waterproof tape 421 of FIG. 4) (e.g., in the z-axis direction) to press the first waterproof tape 421 and the second waterproof tape (e.g., the second waterproof tape 423 in FIG. 4) disposed below the conductive plate 420 (e.g., in the -z-axis direction), and being fastened to one surface of the support member 311 via a pair of locking devices 515. Accordingly, it is possible to prevent the first waterproof tape 421 and the second waterproof tape 423 from lifting via the conductive plate 420 and the pair of locking devices 515.

In FIG. 5A according to various embodiments, the charges accumulated (or generated) outside the electronic device 400 (e.g., charges generated and accumulated on the key button 411) may be transferred to the ground inside the electronic device 400 via the flexible circuit board 415, an area of the flexible circuit board 415 with which one surface (e.g., the surface facing the z-axis direction) of the tension rib 555 of the conductive plate 420 is in contact (e.g., at least a partial area of the conductive layer of the flexible circuit board 415 exposed to outside), the pair of locking devices 515, and the support member 311.

Referring to [510] of FIG. 5B, the tension rib 555 may be provided (e.g., formed) on at least a portion of the conductive plate 420. For example, the tension rib 555 may be provided in a slit shape in at least a portion of the conductive plate 420. In an embodiment, when the conductive plate 420 is fixed by being fastened to the support member 311 via the pair of locking devices 515, the tension rib 555 provided in at least a portion of the conductive plate 420 in the slit shape may be in elastic contact with at least a partial area 560 of the flexible circuit board 415 (e.g., at least a partial area of the conductive layer of the flexible circuit board 415 exposed to outside).

In an embodiment, [570] of FIG. 5B illustrates at least a partial area of the conductive layer of the flexible circuit board 415 exposed to outside as the insulating layer on the external surface of the flexible circuit board 415 is removed. In an embodiment, the tension rib 555 provided in at least a partial area of the conductive plate 420 may be in elastic contact with at least the partial area 560 of the conductive layer exposed to outside the flexible circuit board 415.

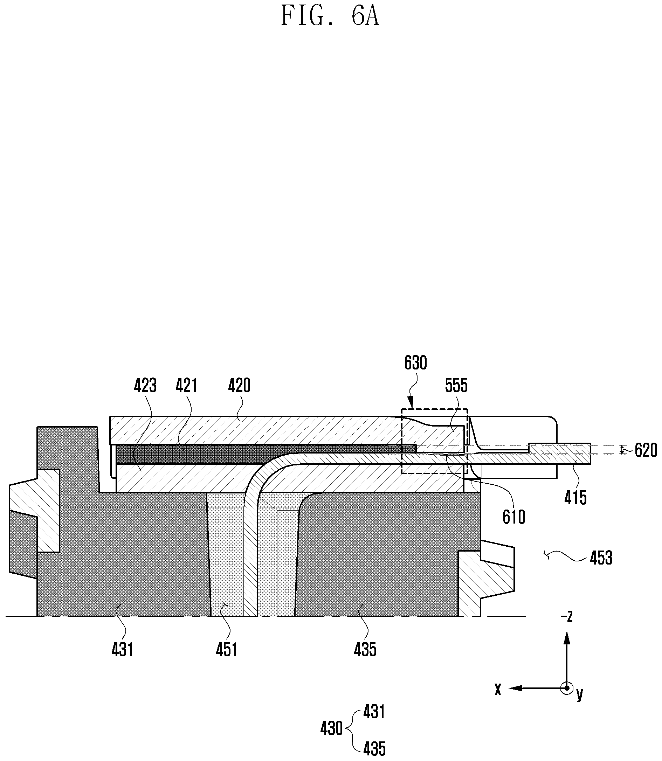

FIG. 6A is a cross-sectional view taken along line B-B' in FIG. 5B according to an embodiment of the disclosure.

Referring to FIG. 6A, the electronic device (e.g., the electronic device 400 of FIG. 4) may include a waterproof structure disposed between a support member (e.g., the first support member 311 of FIG. 3) and a key button assembly (e.g., the key button assembly 410 of FIG. 4). The waterproof structure may include a conductive plate 420, a first waterproof tape 421, and a second waterproof tape 423 that spatially isolate a first space 451 in which the key button assembly 410 is located and a second space 453 in which a printed circuit board (e.g., the printed circuit board 340 of FIG. 3) is located from each other (or close a second opening (e.g., the second opening 403 in FIG. 4)).

In an embodiment, the second waterproof tape 423 may be attached to one surface of the first waterproof tape 421 (e.g., the surface facing the z-axis direction), and the conductive plate 420 may be attached to the other surface (e.g., the surface facing the -z-axis direction). The first waterproof tape 421 may be attached to one surface (e.g., the surface facing the -z-axis direction) of the second waterproof tape 423, and the key structure 430 (e.g., the key bracket 431 and/or front dummy 435) may be attached to the other surface (e.g., the surface facing the z-axis direction).

In an embodiment, at least a portion of the flexible circuit board 415 may pass through the space between the first waterproof tape 421 and the second waterproof tape 423 and through the space between one surface 610 (e.g., the surface facing the z-axis direction) of a tension rib 555 of the conductive plate 420 and the second waterproof tape 423, and may then be electrically connected to a printed circuit board 340.

In an embodiment, the tension rib 555 may be provided in a slit shape in a partial area of the conductive plate 420. The one surface 610 (e.g., the surface facing the z-axis direction) of the tension rib 555 in the conductive plate 420 may have a step lower than one surface (e.g., the surface facing the z-axis direction) of the conductive plate 420 on which the tension rib 555 is not provided. For example, the one surface 610 (e.g., the surface facing the z-axis direction) of the tension rib 555 and the one surface (e.g., the surface facing the z-axis direction) of the conductive plate 420 on which the tension rib 555 is not provided may have a predetermined length difference 620 (e.g., about 0.1 mm).

In an embodiment, since the one surface 610 (e.g., the surface facing the z-axis direction) of the tension rib 555 may have a step lower than the one surface (e.g., the surface facing the z-axis direction) of the conductive plate 420 on which the tension rib 555 is not provided and the one surface 610 of the tension rib 555 is in elastic contact with at least a partial area of the flexible circuit board 415 (e.g., at least a partial area of the conductive layer of the flexible circuit board 415 exposed to outside), the electrical contact of the one surface 610 of the tension rib 555 to at least a partial area of the flexible circuit board 415 (e.g., at least a partial area of the conductive layer of the flexible circuit board 415 exposed to outside) may be maintained.

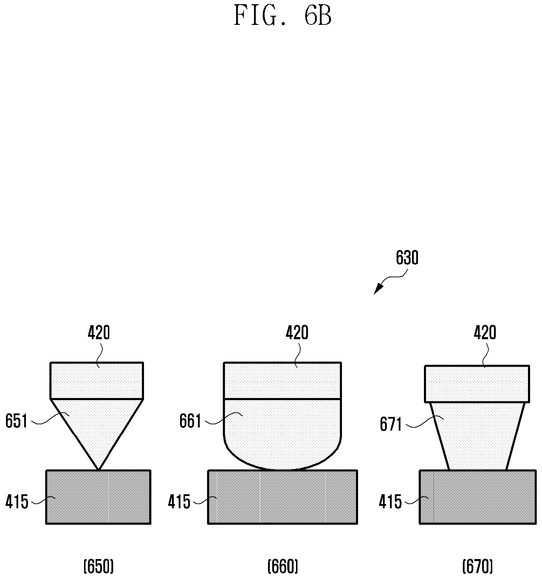

FIG. 6B is a view illustrating examples of shapes of a portion indicated by reference number 630 in FIG. 6A according to an embodiment of the disclosure.

Referring to FIG. 6B, the area of the conductive plate 420 that comes into electrical contact with at least a partial area of the flexible circuit board 415 (e.g., at least a partial area of the conductive layer of the flexible circuit board 415 exposed to outside) (e.g., 560 of FIG. 5B) may have various shapes. For example, as illustrated in reference number [650], the area of the conductive plate 420 that is in contact with at least the partial area 560 of the flexible circuit board 415 (e.g., at least a partial area of the conductive layer of the flexible circuit board 415 exposed to outside) may be implemented in an inverted triangular shape 651. As another example, as illustrated in reference number [660], the area of the conductive plate 420 that is in contact with at least the partial area 560 of the flexible circuit board 415 (e.g., at least a partial area of the conductive layer of the flexible circuit board 415 exposed to outside) may be implemented in a shape rounded at the corners. As another example, as illustrated in reference number [670], the area of the conductive plate 420 that comes into contact with at least the partial area 560 of the flexible circuit board 415 (e.g., at least a partial area of the conductive layer of the flexible circuit board 415 exposed to outside) may be implemented in an inverted trapezoidal shape 671.

FIG. 7A is a view illustrating a conductive pattern 720 provided (e.g., formed) in a sensor circuit 705 according to an embodiment of the disclosure.

As described above with reference to FIG. 4, a key button assembly (e.g., the key button assembly 410 of FIG. 4) may further include a sensor circuit 705.

Referring to FIG. 7A, the sensor circuit 705 may include a plurality of terminals 710 and the first conductive pattern 720. The plurality of terminals 710 and the first conductive pattern 720 may be provided on one surface of the sensor circuit 705, for example, on the surface facing the -x-axis direction. The first conductive pattern 720 may be provided inside the sensor circuit 705 in the form of surrounding the outer periphery of the sensor circuit 705. For example, an insulating layer and a conductive layer (e.g., a copper foil) may be applied (or attached) to one surface (or both surfaces) of the sensor circuit 705, and the external surface of the sensor circuit 705 may be provided by the insulating layer. As the insulating layer provided on the external surface of the sensor circuit 705 is removed in the form of surrounding the outside of the sensor circuit 705 (e.g., in the form of surrounding the plurality of terminals 710) and at least a portion of the conductive layer provided under the insulating layer is exposed, the first conductive pattern 720 may be provided.

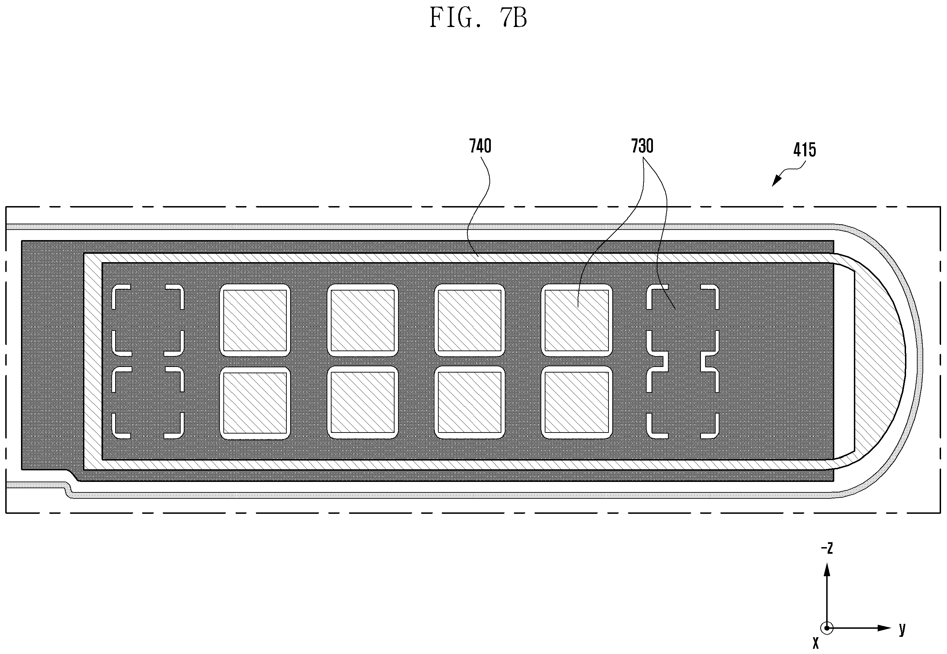

FIG. 7B is a view illustrating a conductive pattern 740 provided on the flexible circuit board 415 according to an embodiment of the disclosure.

Referring to FIG. 7B, a sensor circuit 705 is located on one surface (e.g., the surface facing the x-axis direction) of the flexible circuit board 415, and a dome switch 417 may be located on the other surface (e.g., the surface facing the -x-axis direction) of the flexible circuit board 415.

In an embodiment, the flexible circuit board 415 may include a plurality of terminals 730 and/or a second conductive pattern 740. The plurality of terminals 730 and the second conductive pattern 740 may be provided (e.g., formed) on one surface (e.g., the surface facing the -x-axis direction) of the flexible circuit board 415. The second conductive pattern 740 may be provided inside the flexible circuit board 415 to surround the plurality of terminals 730 of the flexible circuit board 415. For example, an insulating layer and a conductive layer (e.g., a copper foil) may be applied (or attached) to one surface (or both surfaces) of the flexible circuit board 415, and the external surface of the flexible circuit board 415 may be provided by the insulating layer. The second conductive pattern 740 may be provided by removing the insulating layer provided on the external surface of the flexible circuit board 415 in the form of surrounding the plurality of terminals 730 to expose at least a portion of the conductive layer provided under the insulating layer.

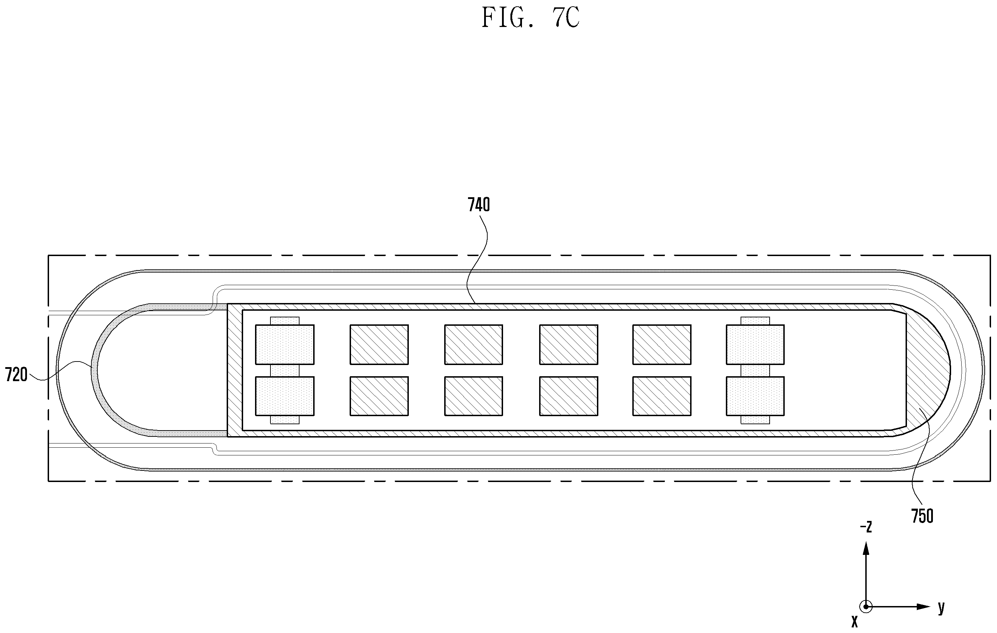

FIG. 7C is a view illustrating a state in which the sensor circuit 705 and the flexible circuit board 415 according to an embodiment of the disclosure overlap each other.

Referring to FIG. 7C, in an embodiment, the sensor circuit 705 and the flexible circuit board 415 may be bonded to each other. For example, as the sensor circuit 705 and the flexible circuit board 415 are bonded to each other, the plurality of terminals 710 of the sensor circuit 705 and the plurality of terminals 730 of the flexible circuit board 415 may be brought into electrical contact with each other. For example, the plurality of terminals 710 provided (e.g., formed) on one surface (e.g., the surface facing the -x-axis direction) of the sensor circuit 705 and the plurality of terminals 730 provided on one surface (e.g., the surface facing the x-axis direction) of the flexible circuit board 415 may brought into electrical contact with each other. In an embodiment, since the sensor circuit 705 operates as a physical key button, it may be necessary to maintain flatness, and the flatness of the sensor circuit 705 and the flatness of the flexible circuit board 415 may be matched by bonding the sensor circuit 705 and the flexible circuit board 415 to each other.

In an embodiment, the first conductive pattern 720 of the sensor circuit 705 and the second conductive pattern 740 of the flexible circuit board 415 may be electrically connected to each other via a conductive adhesive (e.g., a conductive liquid material). After matching the flatness of the sensor circuit 705 and the flatness of the flexible circuit board 415, the conductive adhesive (e.g., a conductive liquid material) may be injected into the space 750 between the sensor circuit 705 and the flexible circuit board 415. By injecting the conductive adhesive (e.g., conductive liquid material) into the space 750 between the sensor circuit 705 and the flexible circuit board 415, the lifting space between the sensor circuit 705 and the flexible circuit board 415 may be filled with the conductive adhesive. Accordingly, the first conductive pattern 720 of the sensor circuit 705 and the second conductive pattern 740 of the flexible circuit board 415 may be electrically connected to each other via the conductive adhesive (e.g., a conductive liquid material).

In an embodiment, the conductive adhesive may include silver epoxy. In an embodiment, the conductive adhesive may be cured by a heat curing method or an ultraviolet curing method.

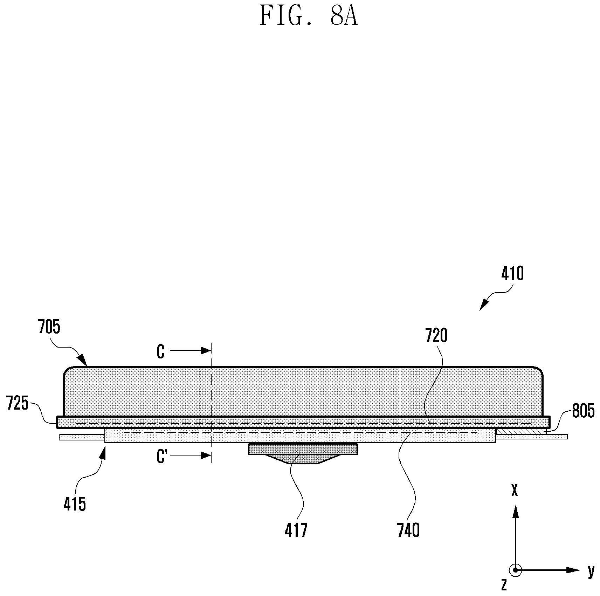

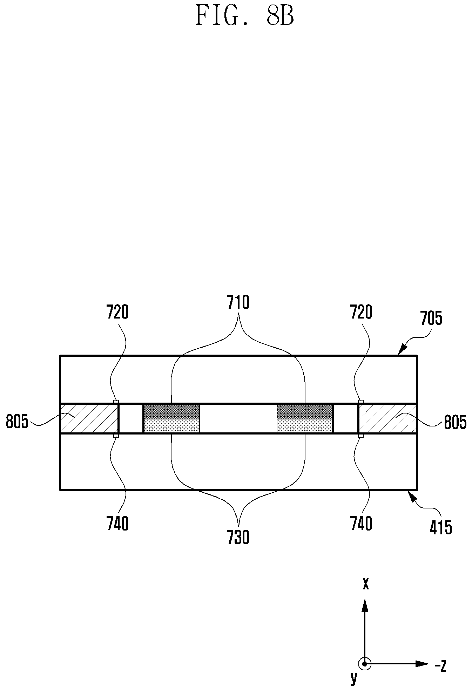

FIG. 8A is a view illustrating a key button assembly 410 according to an embodiment of the disclosure. FIG. 8B is a cross-sectional view taken along line C-C' of FIG. 8A according to an embodiment of the disclosure.

Referring to FIGS. 8A and 8B, a key button assembly (e.g., the key button assembly 410 of FIG. 4) may include a sensor circuit 705, a flexible circuit board 415, and a dome switch 417.

In an embodiment, the sensor circuit 705 and the flexible circuit board 415 may be electrically connected to each other via a sensor solder 725. For example, the sensor circuit 705 and the flexible circuit board 415 may be electrically connected to each other by bringing a plurality of terminals (e.g., the plurality of terminals 710 in FIG. 7A) of the sensor circuit 705 and a plurality of terminals (e.g., the plurality of terminals 730 in FIG. 7B) of the flexible circuit board 415 into electrical contact with each other. In an embodiment, the sensor circuit 705 may be disposed on one area or one surface (e.g., the surface facing the x-axis direction) of the flexible circuit board 415, and the dome switch 417 may be disposed on another area or the other surface (e.g., the surface facing the -x-axis direction) of the flexible circuit board 415.

In an embodiment, the first conductive pattern (e.g., the first conductive pattern 720 of FIG. 7A) of the sensor circuit 705 and the second conductive pattern (e.g., the second conductive pattern 740 of FIG. 7B) of the flexible circuit board 415 may be electrically connected to each other via a conductive adhesive 805 (e.g., a conductive liquid material). Via the conductive adhesive 805, the first conductive pattern 720 of the sensor circuit 705 and the second conductive pattern 740 of the flexible circuit board 415 may be electrically connected to each other, and the flexible circuit board 415 may be electrically connected to a ground of a printed circuit board (e.g., the printed circuit board 340 of FIG. 3).

In FIGS. 7A to 8B according to various embodiments, the electronic device 400 may be provided (e.g., formed) with an ESD path such that charges accumulated (or generated) outside the electronic device 400 (e.g., charges generated and accumulated on the key button 411) are transferred to the first conductive pattern 720, the second conductive pattern 740, and the ground of the printed circuit board 340.

In various embodiments, when the above-described embodiment according to FIGS. 4 to 6B and the embodiment according to FIGS. 7A to 8B are both applied, the electronic device 400 may be provided (e.g., formed) with a first ESD path configured to cause charges accumulated (or generated) outside the electronic device 400) (e.g., the charges generated and accumulated on the key button 411) to be transferred to the flexible circuit board 415, an area of the flexible circuit board 415 with which one surface (e.g., the surface facing the z-axis direction) of the tension rib 555 of the conductive plate 420 is in contact (e.g., at least a partial area of the conductive layer of the flexible circuit board 415 exposed to outside), and the ground inside the electronic device 400 (and/or the ground of the printed circuit board 340) connected to the support member 311, and a second ESD path configured to cause the charges to be transferred to the first conductive pattern 720, the second conductive pattern 740, and the ground of the printed circuit board 340.

An electronic device 101, 200, 300, or 400 according to an embodiment of the disclosure includes a housing 210 including a first opening 401. The electronic device 101, 200, 300, or 400 includes a key button 411 disposed to be at least partially exposed to outside through a first opening 401, and a flexible circuit board (FPCB) 415 including one end attached to the key button 411 and the other end electrically connected to a printed circuit board 340 disposed in the inner space of the housing 210. The electronic device 101, 200, 300, or 400 includes a key structure 430 configured to support at least a portion of a key button assembly 410 including the key button 411 and the flexible circuit board 415 in the inner space of the housing 210 and may include a second opening 403. The electronic device 101, 200, 300, or 400 includes a conductive plate 420 disposed on the key structure 430 to close the second opening 403 included in the key structure 430. The electronic device 101, 200, 300, or 400 includes a support member 311 in which the key structure 430 is accommodated. The flexible circuit board 415 included in the electronic device 101, 200, 300, or 400 extends between the key structure 430 and the conductive plate 420 from the first opening 401 through the second opening 403. At least a portion of the conductive plate 420 included in the electronic devices 101, 200, 300, or 400 is electrically connected, via at least the partial area 560 of the flexible circuit board 415, to a ground inside the electronic device 101, 200, 300, or 400, the ground being connected to the support member 311.

In an embodiment, a tension rib 555 may be provided on at least a portion of the conductive plate 420.

In an embodiment, the tension rib 555 may be provided in a slit shape in at least a portion of the conductive plate 420.

In an embodiment, one surface 610 of the tension rib 555 in the conductive plate 420 may have a step lower than one surface of the conductive plate 420 on which the tension rib 555 is not provided.

In an embodiment, an insulating layer and a conductive layer may be alternately stacked on one surface of the flexible circuit board 415.

In an embodiment, an external surface of the flexible circuit board 415 is provided by the insulating layer.

In an embodiment, at least a portion of the insulating layer provided on the external surface of the flexible circuit board 415 may be removed so that at least the partial area 560 of the conductive layer provided under the insulating layer can be exposed to outside.

In an embodiment, the tension rib 555 of the conductive plate 420 may be in contact with at least the partial area 560 of the conductive layer exposed to outside from the flexible circuit board 415.

In an embodiment, the electronic device 101, 200, 300, or 400 may be provided with an ESD path such that charges introduced from outside the key button 411 are transferred to a ground of the printed circuit board 340 via the flexible circuit board 415 and at least the partial area 560 of the flexible circuit board 415 with which one surface of the tension rib 555 of the conductive plate 420 is in contact.

In an embodiment, the electronic device 101, 200, 300, or 400 may be provided with an ESD path such that charges introduced from outside the key button 411 are transferred to a ground inside the electronic device 400 via the flexible circuit board 415, at least the partial area 560 of the flexible circuit board 415 with which one surface of the tension rib 555 of the conductive plate 420 is in contact, and the support member 311.

In an embodiment, the area of the conductive plate 420, which is in electrical contact with at least the partial area 560 of the flexible circuit board 415, may have an inverted triangular shape 651, a shape 661 rounded at corners, or an inverted trapezoidal shape 671.

In an embodiment, the electronic device 101, 200, 300, or 400 may further include a first waterproof tape 421 and a second waterproof tape 423 disposed between the key structure 430 and the conductive plate 420.

In an embodiment, the first waterproof tape 421 and the second waterproof tape 423 may be disposed under the conductive plate 420.

In an embodiment, the conductive plate 420 may press the first waterproof tape 421 and the second waterproof tape 423 to prevent the first waterproof tape 421 and the second waterproof tape 423 from lifting.

In an embodiment, the conductive plate 420 may be fastened to one surface of the support member 311 disposed in the inner space of the electronic device 400 via a locking device 515.

In an embodiment, the key button assembly 410 may further include a sensor circuit 705.

The electronic device 101, 200, 300, or 400 according to an embodiment of the disclosure includes a housing 210 including an opening 401. The electronic device 101, 200, 300, or 400 includes a sensor circuit 705 disposed to be at least partially exposed to outside through the opening 401 and including a first conductive pattern 720, and a flexible circuit board (FPCB) 415 including one end attached to a sensor circuit 705 and the other end electrically connected to a printed circuit board 340 disposed in the inner space of the housing 210. The flexible circuit board 415 included in the electronic device 101, 200, 300, or 400 includes a second conductive pattern 740 electrically connected to the first conductive pattern 720 and electrically connected to a ground of the printed circuit board 340.

In an embodiment, the first conductive pattern 720 may be provided inside the sensor circuit 705 in the form of surrounding a plurality of terminals 710 included in the sensor circuit 705.

In an embodiment, the second conductive pattern 740 may be provided inside the flexible circuit board 415 to surround a plurality of terminals 710 included in the flexible circuit board 415.

In an embodiment, the first conductive pattern 720 and the second conductive pattern 740 may be electrically connected to each other via a conductive adhesive.

In an embodiment, the conductive adhesive may contain silver epoxy.

In an embodiment, the conductive adhesive may be cured by a heat curing method or an ultraviolet curing method.

In an embodiment, the electronic device 101, 200, 300, or 400 may be provided with an ESD path such that charges introduced from outside of the key button 411 are transferred to the first conductive pattern 720, the second conductive pattern 740, and a ground of the printed circuit board 340.

An electronic device 101, 200, 300, or 400 according to an embodiment of the disclosure includes a housing 210 including a first opening 401. The electronic device 101, 200, 300, or 400 includes a sensor circuit 705 disposed to be at least partially exposed to outside through the first opening 401 and including a first conductive pattern 720, and a flexible circuit board (FPCB) 415 including one end attached to a sensor circuit 705 and the other end electrically connected to a printed circuit board 340 disposed in the inner space of the housing 210. The electronic device 101, 200, 300, or 400 includes a key structure 430 configured to support at least a portion of the key button assembly 410 in an inner space of the housing 210 and including a second opening 403. The electronic device 101, 200, 300, or 400 includes a conductive plate 420 disposed on the key structure 430 to close the second opening 403. The electronic device 101, 200, 300, or 400 includes a support member 311 in which the key structure 430 is accommodated. At least a portion of the conductive plate 420 included in the electronic devices 101, 200, 300, or 400 is electrically connected, via at least the partial area 560 of the flexible circuit board 415, to a ground inside the electronic device 101, 200, 300, or 400, the ground being connected to the support member 311. The flexible circuit board 415 included in the electronic device 101, 200, 300, or 400 extends between the key structure 430 and the conductive plate 420 from the first opening 401 through the second opening 403. The flexible circuit board 415 included in the electronic device 101, 200, 300, or 400 includes a second conductive pattern 740 electrically connected to the first conductive pattern 720 and the ground of the printed circuit board 340.

The embodiments of the disclosure disclosed in this specification and drawings are provided merely to propose specific examples in order to easily describe the technical features according to the embodiments of the disclosure and to help understanding of the embodiments of the disclosure.

## Claims

1. An electronic device (101, 200, 300, 400) comprising:
a housing (210) comprising a first opening (401);
a key button (411) disposed to be at least partially exposed outside through the first opening (401);
the electronic device being **characterized in that** it further comprises:
a flexible circuit board, FPCB (415), comprising one end attached to the key button (411) and another end electrically connected to a printed circuit board (340) disposed in an inner space of the housing (210);
a key structure (430), in the inner space of the housing (210), configured to support at least a portion of a key button assembly (410) comprising the key button (411) and the flexible circuit board (415) in the inner space of the housing (210), the key structure (430) comprising a second opening (403);
a conductive plate (420) disposed on the key structure (430) to close the second opening (403); and
a support member (311) in which the key structure (430) is accommodated,
wherein the FPCB (415) extends between the key structure (430) and the conductive plate (420) from the first opening (401) through the second opening (403), and
wherein at least a portion of the conductive plate (420) is electrically connected, via at least a partial area (560) of the FPCB (415), to a ground inside the electronic device (101, 200, 300, 400), the ground being connected to the support member (311).

2. The electronic device of claim 1, wherein a tension rib (555) is provided in at least a portion of the conductive plate (420).

3. The electronic device of claim 2, wherein the tension rib (555) is provided in a slit shape in at least a portion of the conductive plate (420).

4. The electronic device of claim 2 or 3, wherein a lower surface (610) of the tension rib (555) in the conductive plate (420) has a step lower than an upper surface of the conductive plate (420) on which the tension rib (555) is not provided.

5. The electronic device of claim 2 or 3, wherein the FPCB (415) comprises alternately stacked insulating layers and conductive layers,
wherein an external surface of the FPCB (415) is the insulating layer,
wherein at least a partial area of the external insulating layer is removed so that at least the partial area (560) of the conductive layer provided under the external insulating layer is not covered by the external insulating layer to elastically contact the tension rib (555).

6. The electronic device of any of claims 2 to 5, wherein an electrostatic discharge, ESD, path is provided such that charges introduced from outside the key button (411) are transferred to the ground of the printed circuit board (340) via the FPCB (415) and the at least the partial area (560) of the FPCB (415) with which one surface of the tension rib (555) of the conductive plate (420) is in contact, and/or
wherein the ESD path is provided such that charges introduced from outside of the key button (411) are transferred to the ground inside the electronic device (400) via the FPCB (415), at least the partial area (560) of the FPCB (415) with which the one surface of the tension rib (555) of the conductive plate (420) is in contact, and the support member (311).

7. The electronic device of any of claims 4 to 6, wherein the area of the conductive plate (420), which is in electrical contact with at least the partial area (560) of the FPCB (415), has an inverted triangular shape (651), a shape (661) rounded at corners, or an inverted trapezoidal shape (671).

8. The electronic device of any of claims 1 to 7, further comprising a first waterproof tape (421) and a second waterproof tape (423) disposed between the key structure (430) and the conductive plate (420), and
wherein the first waterproof tape (421) and the second waterproof tape (423) are disposed under the conductive plate (420), and
wherein the conductive plate (420) is configured to press the first waterproof tape (421) and the second waterproof tape (423) to prevent the first waterproof tape (421) and the second waterproof tape (423) from lifting,
wherein the conductive plate (420) is fastened to one surface of the support member (311) disposed in the inner space of the electronic device (400) via a locking device (515).

9. The electronic device of claim 1, wherein the key button assembly (410) further comprises a sensor circuit (705).

10. The electronic device (101, 200, 300, 400) of any of claims 1 to 8 further comprising:
a sensor circuit (705) disposed to be at least partially exposed to outside through the first opening (401) and comprising a first conductive pattern (720);
wherein the FPCB (415) comprises a second conductive pattern (740) electrically connected to the first conductive pattern (720) and a ground of the printed circuit board (340).

11. The electronic device of claim 10, wherein the first conductive pattern (720) is provided inside the sensor circuit (705) in a form of surrounding a plurality of terminals (710) included in the sensor circuit (705),
wherein the second conductive pattern (740) is provided inside the FPCB (415) in a form of surrounding a plurality of terminals (730) included in the FPCB (415), and
wherein the first conductive pattern (720) and the second conductive pattern (740) are electrically connected to each other via a conductive adhesive.

12. The electronic device of claim 11, wherein the conductive adhesive contains silver epoxy, and
wherein the conductive adhesive is cured by a heat curing method or an ultraviolet curing method.

13. The electronic device of any of claims 10 to 12, wherein an electrostatic discharge, ESD, path is provided such that charges introduced from outside the key button (411) are transferred to the first conductive pattern (720), the second conductive pattern (740), and the ground of the printed circuit board (340).

## Patentansprüche

1. Elektronische Vorrichtung (101, 200, 300, 400), die Folgendes umfasst:
ein Gehäuse (210), das eine erste Öffnung (401) umfasst;
einen Tastenknopf (411), der so angeordnet ist, dass er durch die erste Öffnung (401) zumindest teilweise nach außen freiliegt;
wobei die elektronische Vorrichtung **dadurch gekennzeichnet ist, dass** sie ferner Folgendes umfasst:
eine flexible Leiterplatte, FPCB, (415), die ein am Tastenknopf (411) befestigtes Ende und ein anderes Ende umfasst, das elektrisch mit einer Leiterplatte (340) verbunden ist, die in einem Innenraum des Gehäuses (210) angeordnet ist;
eine Tastenstruktur (430) im Innenraum des Gehäuses (210), die konfiguriert ist, um zumindest einen Abschnitt einer Tastenknopfbaugruppe (410), die den Tastenknopf (411) und die flexible Leiterplatte (415) umfasst, im Innenraum des Gehäuses (210) zu halten, wobei die Tastenstruktur (430) eine zweite Öffnung (403) umfasst;
eine leitfähige Platte (420), die auf der Tastenstruktur (430) angeordnet ist, um die zweite Öffnung (403) zu verschließen; und
ein Trägerelement (311), in dem die Tastenstruktur (430) aufgenommen ist,
wobei sich die FPCB (415) zwischen der Tastenstruktur (430) und der leitfähigen Platte (420) von der ersten Öffnung (401) durch die zweite Öffnung (403) erstreckt, und
wobei zumindest ein Abschnitt der leitfähigen Platte (420) über zumindest einen Teilbereich (560) der FPCB (415) elektrisch mit einer Masse innerhalb der elektronischen Vorrichtung (101, 200, 300, 400) verbunden ist, wobei die Masse mit dem Trägerelement (311) verbunden ist.

2. Elektronische Vorrichtung nach Anspruch 1, wobei in zumindest einem Abschnitt der leitfähigen Platte (420) eine Spannrippe (555) vorgesehen ist.

3. Elektronische Vorrichtung nach Anspruch 2, wobei die Spannrippe (555) in zumindest einem Abschnitt der leitfähigen Platte (420) in Schlitzform vorgesehen ist.

4. Elektronische Vorrichtung nach Anspruch 2 oder 3, wobei eine Unterseite (610) der Spannrippe (555) in der leitfähigen Platte (420) eine Stufe aufweist, die tiefer liegt als eine Oberseite der leitfähigen Platte (420), an der die Spannrippe (555) nicht vorgesehen ist.

5. Elektronische Vorrichtung nach Anspruch 2 oder 3, wobei die FPCB (415) abwechselnd gestapelte Isolierschichten und leitende Schichten umfasst,
wobei eine Außenfläche der FPCB (415) die Isolierschicht ist,
wobei zumindest ein Teilbereich der äußeren Isolierschicht entfernt ist, sodass zumindest der Teilbereich (560) der unter der äußeren Isolierschicht vorgesehenen leitenden Schicht nicht von der äußeren Isolierschicht bedeckt ist, um die Spannrippe (555) elastisch zu kontaktieren.

6. Elektronische Vorrichtung nach einem der Ansprüche 2 bis 5, wobei ein Pfad für elektrostatische Entladung, ESD, derart vorgesehen ist, dass von außerhalb des Tastenknopfes (411) eingebrachte Ladungen über die FPCB (415) und zumindest den Teilbereich (560) der FPCB (415), mit dem eine Fläche der Spannrippe (555) der leitfähigen Platte (420) in Kontakt steht, an die Masse der Leiterplatte (340) übertragen werden, und/oder
wobei der ESD-Pfad derart vorgesehen ist, dass von außerhalb des Tastenknopfes (411) eingebrachte Ladungen über die FPCB (415), zumindest den Teilbereich (560) der FPCB (415), mit dem die eine Fläche der Spannrippe (555) der leitfähigen Platte (420) in Kontakt steht, und das Trägerelement (311) an die Masse innerhalb der elektronischen Vorrichtung (400) übertragen werden.

7. Elektronische Vorrichtung nach einem der Ansprüche 4 bis 6, wobei der Bereich der leitfähigen Platte (420), der mit zumindest dem Teilbereich (560) der FPCB (415) in elektrischem Kontakt steht, eine umgekehrte Dreiecksform (651), eine an den Ecken abgerundete Form (661) oder eine umgekehrte Trapezform (671) aufweist.

8. Elektronische Vorrichtung nach einem der Ansprüche 1 bis 7, ferner umfassend ein erstes wasserdichtes Klebeband (421) und ein zweites wasserdichtes Klebeband (423), die zwischen der Tastenstruktur (430) und der leitfähigen Platte (420) angeordnet sind, und
wobei das erste wasserdichte Klebeband (421) und das zweite wasserdichte Klebeband (423) unter der leitfähigen Platte (420) angeordnet sind, und
wobei die leitfähige Platte (420) konfiguriert ist, um das erste wasserdichte Klebeband (421) und das zweite wasserdichte Klebeband (423) anzudrücken, um zu verhindern, dass sich das erste wasserdichte Klebeband (421) und das zweite wasserdichte Klebeband (423) abheben,
wobei die leitfähige Platte (420) über eine Verriegelungsvorrichtung (515) an einer Fläche des im Innenraum der elektronischen Vorrichtung (400) angeordneten Trägerelements (311) befestigt ist.

9. Elektronische Vorrichtung nach Anspruch 1, wobei die Tastenknopfbaugruppe (410) ferner eine Sensorschaltung (705) umfasst.

10. Elektronische Vorrichtung (101, 200, 300, 400) nach einem der Ansprüche 1 bis 8, ferner umfassend:
eine Sensorschaltung (705), die so angeordnet ist, dass sie durch die erste Öffnung (401) zumindest teilweise nach außen freiliegt, und die ein erstes Leiterbild (720) umfasst;
wobei die FPCB (415) ein zweites Leiterbild (740) umfasst, das elektrisch mit dem ersten Leiterbild (720) und einer Masse der Leiterplatte (340) verbunden ist.

11. Elektronische Vorrichtung nach Anspruch 10, wobei das erste Leiterbild (720) innerhalb der Sensorschaltung (705) in einer Form vorgesehen ist, die eine Vielzahl von Anschlüssen (710) umgibt, die in der Sensorschaltung (705) enthalten sind,
wobei das zweite Leiterbild (740) innerhalb der FPCB (415) in einer Form vorgesehen ist, die eine Vielzahl von Anschlüssen (730) umgibt, die in der FPCB (415) enthalten sind, und
wobei das erste Leiterbild (720) und das zweite Leiterbild (740) über einen leitfähigen Klebstoff elektrisch miteinander verbunden sind.

12. Elektronische Vorrichtung nach Anspruch 11, wobei der leitfähige Klebstoff Silberepoxid enthält, und
wobei der leitfähige Klebstoff durch ein Wärmehärtungsverfahren oder ein Ultraviolett-Härtungsverfahren gehärtet wird.

13. Elektronische Vorrichtung nach einem der Ansprüche 10 bis 12, wobei ein Pfad für elektrostatische Entladung, ESD, derart vorgesehen ist, dass von außerhalb des Tastenknopfes (411) eingebrachte Ladungen an das erste Leiterbild (720), das zweite Leiterbild (740) und die Masse der Leiterplatte (340) übertragen werden.

## Revendications

1. Dispositif électronique (101, 200, 300, 400) comprenant :
un boîtier (210) comprenant une première ouverture (401) ;
un bouton de touche (411) disposé de manière à être au moins partiellement exposé vers l'extérieur à travers la première ouverture (401) ;
le dispositif électronique étant **caractérisé en ce qu'**il comprend en outre :
une carte de circuit imprimé flexible, FPCB, (415) comprenant une extrémité fixée au bouton de touche (411) et une autre extrémité connectée électriquement à une carte de circuit imprimé (340) disposée dans un espace intérieur du boîtier (210) ;
une structure de touche (430), dans l'espace intérieur du boîtier (210), configurée pour supporter au moins une partie d'un ensemble de bouton de touche (410) comprenant le bouton de touche (411) et la carte de circuit imprimé flexible (415) dans l'espace intérieur du boîtier (210), la structure de touche (430) comprenant une deuxième ouverture (403) ;
une plaque conductrice (420) disposée sur la structure de touche (430) pour fermer la deuxième ouverture (403) ; et
un élément de support (311) dans lequel la structure de touche (430) est logée,
dans lequel la FPCB (415) s'étend entre la structure de touche (430) et la plaque conductrice (420) depuis la première ouverture (401) à travers la deuxième ouverture (403), et
dans lequel au moins une partie de la plaque conductrice (420) est connectée électriquement, par l'intermédiaire d'au moins une zone partielle (560) de la FPCB (415), à une masse à l'intérieur du dispositif électronique (101, 200, 300, 400), la masse étant connectée à l'élément de support (311).

2. Dispositif électronique de la revendication 1, dans lequel une nervure de tension (555) est prévue dans au moins une partie de la plaque conductrice (420).

3. Dispositif électronique de la revendication 2, dans lequel la nervure de tension (555) est prévue en forme de fente dans au moins une partie de la plaque conductrice (420).

4. Dispositif électronique de la revendication 2 ou 3, dans lequel une surface inférieure (610) de la nervure de tension (555) dans la plaque conductrice (420) présente un décrochement plus bas qu'une surface supérieure de la plaque conductrice (420) sur laquelle la nervure de tension (555) n'est pas prévue.

5. Dispositif électronique de la revendication 2 ou 3, dans lequel la FPCB (415) comprend des couches isolantes et des couches conductrices empilées en alternance,
dans lequel une surface externe de la FPCB (415) est la couche isolante,
dans lequel au moins une zone partielle de la couche isolante externe est retirée de sorte qu'au moins la zone partielle (560) de la couche conductrice prévue sous la couche isolante externe n'est pas recouverte par la couche isolante externe pour entrer en contact élastique avec la nervure de tension (555).

6. Dispositif électronique de l'une quelconque des revendications 2 à 5, dans lequel un chemin de décharge électrostatique, ESD, est prévu de sorte que des charges introduites depuis l'extérieur du bouton de touche (411) sont transférées à la masse de la carte de circuit imprimé (340) par l'intermédiaire de la FPCB (415) et de l'au moins une zone partielle (560) de la FPCB (415) avec laquelle une surface de la nervure de tension (555) de la plaque conductrice (420) est en contact, et/ou
dans lequel le chemin ESD est prévu de sorte que des charges introduites depuis l'extérieur du bouton de touche (411) sont transférées à la masse à l'intérieur du dispositif électronique (400) par l'intermédiaire de la FPCB (415), d'au moins la zone partielle (560) de la FPCB (415) avec laquelle la surface de la nervure de tension (555) de la plaque conductrice (420) est en contact, et de l'élément de support (311).

7. Dispositif électronique de l'une quelconque des revendications 4 à 6, dans lequel la zone de la plaque conductrice (420), qui est en contact électrique avec au moins la zone partielle (560) de la FPCB (415), présente une forme triangulaire inversée (651), une forme (661) arrondie aux coins ou une forme trapézoïdale inversée (671).

8. Dispositif électronique de l'une quelconque des revendications 1 à 7, comprenant en outre un premier ruban étanche (421) et un deuxième ruban étanche (423) disposés entre la structure de touche (430) et la plaque conductrice (420), et
dans lequel le premier ruban étanche (421) et le deuxième ruban étanche (423) sont disposés sous la plaque conductrice (420), et
dans lequel la plaque conductrice (420) est configurée pour presser le premier ruban étanche (421) et le deuxième ruban étanche (423) afin d'empêcher le premier ruban étanche (421) et le deuxième ruban étanche (423) de se soulever,
dans lequel la plaque conductrice (420) est fixée à une surface de l'élément de support (311) disposé dans l'espace intérieur du dispositif électronique (400) par l'intermédiaire d'un dispositif de verrouillage (515).

9. Dispositif électronique de la revendication 1, dans lequel l'ensemble de bouton de touche (410) comprend en outre un circuit de capteur (705).

10. Dispositif électronique (101, 200, 300, 400) de l'une quelconque des revendications 1 à 8, comprenant en outre :
un circuit de capteur (705) disposé de manière à être au moins partiellement exposé vers l'extérieur à travers la première ouverture (401) et comprenant un premier motif conducteur (720) ;
dans lequel la FPCB (415) comprend un deuxième motif conducteur (740) connecté électriquement au premier motif conducteur (720) et à une masse de la carte de circuit imprimé (340).

11. Dispositif électronique de la revendication 10, dans lequel le premier motif conducteur (720) est prévu à l'intérieur du circuit de capteur (705) sous une forme entourant une pluralité de bornes (710) incluses dans le circuit de capteur (705),
dans lequel le deuxième motif conducteur (740) est prévu à l'intérieur de la FPCB (415) sous une forme entourant une pluralité de bornes (730) incluses dans la FPCB (415), et
dans lequel le premier motif conducteur (720) et le deuxième motif conducteur (740) sont connectés électriquement l'un à l'autre par l'intermédiaire d'un adhésif conducteur.

12. Dispositif électronique de la revendication 11, dans lequel l'adhésif conducteur contient de l'époxy à l'argent, et
dans lequel l'adhésif conducteur est durci par un procédé de durcissement thermique ou un procédé de durcissement par ultraviolets.

13. Dispositif électronique de l'une quelconque des revendications 10 à 12, dans lequel un chemin de décharge électrostatique, ESD, est prévu de sorte que des charges introduites depuis l'extérieur du bouton de touche (411) sont transférées au premier motif conducteur (720), au deuxième motif conducteur (740) et à la masse de la carte de circuit imprimé (340).
